(19) Europäisches Patentamt / European Patent Office / Office européen des brevets

(11) **EP 4 369 883 A1**

(12) **EUROPEAN PATENT APPLICATION**

(43) Date of publication:
**15.05.2024 Bulletin 2024/20**

(21) Application number: **22206549.2**

(22) Date of filing: **10.11.2022**

(51) International Patent Classification (IPC):
**H10B 61/00** (2023.01)   **H10N 50/01** (2023.01)
**H10N 50/10** (2023.01)   **H10N 60/12** (2023.01)
**H10N 69/00** (2023.01)

(52) Cooperative Patent Classification (CPC):
**H10N 50/01; H10B 61/00; H10N 50/10;
H10N 60/12; H10N 69/00**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**KH MA MD TN**

(71) Applicant: **Max-Planck-Gesellschaft zur
Förderung der
Wissenschaften e.V.
80539 München (DE)**

(72) Inventor: **PARKIN, Stuart S.P.
06118 Halle (DE)**

(74) Representative: **Schweitzer, Klaus
Plate Schweitzer Zounek
Patentanwälte
Rheingaustrasse 196
65203 Wiesbaden (DE)**

(54) **RACETRACK MEMORY WITH READING ELEMENT BASED ON POLARITY-REVERSIBLE JOSEPHSON SUPERCURRENT DIODE**

(57)    The present disclosure relates to a Racetrack (RT) memory, comprising a racetrack layer and at least one reading element, wherein the reading element comprises a polarity-reversible Josephson supercurrent diode (= JJ).

Figure 5

## Description

The present invention relates to a racetrack memory device with an improved reading element, more specifically to a racetrack memory wherein the reading element comprises a polarity-reversible Josephson supercurrent diode, which is capable of detecting magnetic domains and thus magnetic domain walls in the racetrack.

Background

Today we live in a digital world in which ever-increasing massive quantities of data are stored in the "cloud", with concomitantly ever more energy consumption. At the same time, the evolution of conventional silicon-based computing systems has reached the end of Moore's law. Novel memory and computing devices are needed that can use less energy. The leading non-volatile, high-performance memories today are, arguably the spintronic memories MRAM (Magnetoresistive Random Access Memory) and RTM (Racetrack Memory) [see e.g. US-B 6,834,005; US-A 2014/204648], MRAM like many other conventional memories does not function well at low temperatures: MRAM requires thermal fluctuations for its operation that are suppressed at low temperatures. On the other hand, RTM is deterministic and thus, in principle, can operate even at the lowest temperatures. RTM is unique among memories in that it is a "shift register" in which data is encoded by the presence or absence of chiral domain walls and these data bits are shifted back and forth concurrently along magnetic nano-wires or "racetracks" by current pulses.

Aside from the challenge to store ever-increasing massive quantities of data at the lowest possible energy consumption, there is great interest today in developing quantum computers to perform tasks that are not possible with classical computing. Quantum computing goes beyond the concept of encoding data in memories and logic circuits as "1"s and "0"s to rather using the phase of a wavefunction that can take any value. The most advanced of these use superconducting or spin qubits and operate at ultra-low temperatures (~10-20 mK), well below room temperature. Most research efforts are focused on the analog quantum memory and logic gates and extending their coherence times, as well as developing circuits that incorporate them. Highfrequency signals (GHz) are needed to set up and read out these qubits and the number of the needed signal lines goes in tandem with the number of qubits. For practical applications, vast increases in the number of qubits are needed beyond what is possible today (~70). The heat load of this wiring and the large complexity of the needed electronics means that scaling up to large number of qubits within a dilution refrigerator is very difficult. To overcome this issue, classical control circuits are typically operated at room temperature, although significant efforts to develop cryo-CMOS that could operate at lower temperatures but above that of the quantum qubits, are being spent. The significant physical separation of the digital control circuits from the analogue quantum cores results in significant latency and performance issues.

A critical bottleneck device in high-performance racetrack memory devices is the reading element, which determines how and at what speed the data are read out from the memory. Specifically, in order to increase read-out speed it would be desirable to work with superconducting materials which would operate at the lowest possible resistance and, therefore, highest speed, and, at the same time consume less energy.

One of the most interesting phenomena in superconductivity is the Josephson effect. The Josephson effect produces a current, known as a supercurrent that flows continuously without any voltage applied, across a device known as a Josephson junction (JJ). A JJ consists of two (or more) superconductors coupled by a weak link which is normally not superconducting. The weak link can be a thin insulating barrier (known as a superconductor-insulator-superconductor junction, or S-I-S), a short section of a non-superconducting metal (S-N-S), or a physical constriction that weakens the superconductivity at the point of contact (S-c-S).

Since the discovery of the Josephson effect, there have been many studies to develop memory devices and logic circuits utilizing the non-linear response of a Josephson junction (JJ) as a computing and (volatile) memory element with the potential of energy-efficient, ultrafast computing. Switches based on JJs can in principle, operate at speeds in the sub-THz (picosecond) regime with very low heat dissipation. Even though current supercomputing technology requires energy for cryogenic cooling, it nevertheless offers a significant competitive advantage over CMOS technology when scaled to the exascale, i.e. ~$1 \times 10^{18}$ FLOPS (floating point operations per sec) or more.

A Josephson Junction displays a critical current below which a supercurrent can flow and above which the device is no longer superconducting. In a JJ, the critical current that flows between the superconducting electrodes takes the same value for current that flows in either direction (from the first to the second or from the second to the first electrode). Recently it has been found that a JJ can exhibit a diode effect where the critical current takes distinct values for these two current directions, i.e. the device exhibits a current polarity. In order for such a Josephson Diode to operate, time reversal symmetry must be broken. Time reversal symmetry (TRS) can be broken by the application of a magnetic field when the material forming the weak link is not intrinsically TRS broken (e.g. by being innately magnetic). Thus, in the presence of a magnetic field the JJ can be superconducting with a positive current while being resistive with a negative current, or vice versa. The magnetic field results in a breaking of TRS, which is needed for the diode effect to take place.

Since a magnetic field is required for the Josephson effect for materials without TRS breaking it is desirable to use the magnetic regions of the (moving) magnetic domains in a racetrack memory to trigger the polarity dependent Josephson effect in a Josephson Diode so that the Josephson Diode can be used in a racetrack memory as a reading element.

Object of the Invention

It was, therefore, an object of the present invention to provide a racetrack memory wherein the reading element comprises a polarity-reversible Josephson supercurrent diode, which is capable of detecting domains and thus domain walls in a racetrack memory.

Brief description of the invention

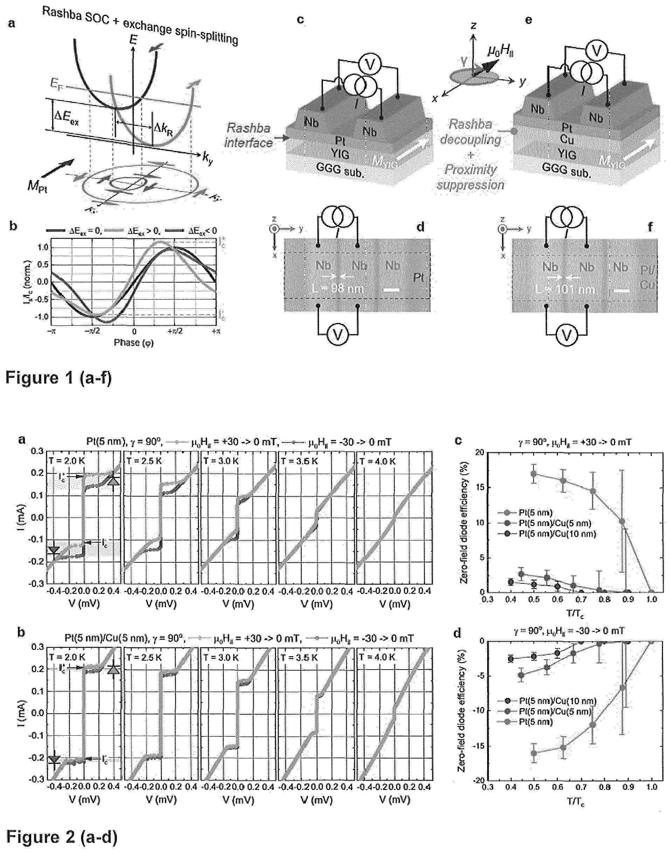

The above objects are met by a racetrack memory wherein the reading element comprises a polarity-reversible Josephson Diode (= JD). Such a JD is capable of using the direction of the magnetic region in a racetrack (up or down) for triggering the Josephson Diode Effect (JDE) so that either a supercurrent flows through the Josephson Junction or a normal current flows so that voltage across the Josephson Junction (either zero or finite) can then be used to detect the domains and thus the domain walls (DW) of the racetrack. The proposed Josephson Diode comprises two or more superconducting electrodes, which are each separated by an ultrathin crystalline Pt layer or Pt-alloy layer (Fig. 1c). This specific JD is magnetized by the magnetic regions of a racetrack that is situated in close proximity to the Pt layer or Pt-alloy layer.

Brief description of the Drawings

**Figure 1. Josephson $\varphi_0$-junction with a proximity-magnetised Pt barrier.**

Fig. 1a: Schematic illustration of nontrivial in-plane (IP) spin-textured Fermi contour of the magnetic Rashba-type Pt barrier in $k$-space. The IP internal/exchange fields $\Delta E_{ex}$ split spin-up and spin-down bands vertically whereas the Rashba SOC $\Delta k_R$ ($\propto \alpha_R$) shift the bands horizontally.

Fig. 1b: Associated non-sinusoidal current-phase relation (CPR) of a Josephson junction (JJ) with the magnetic Rashba-type Pt barrier. In addition to the non-sinusoidal CPR, the inclusion of $I_{c2}\sin(2\varphi)$ makes the positive- and negative $I$ branches unequal ( $I_c^+ \neq |I_c^-|$ ), that is, the Josephson supercurrent rectification.

Fig. 1c is a schematic of the JD.

Fig. 1d is a scanning electron micrograph of the fabricated Nb/Pt/Nb lateral JJs. Here, the ultrathin Pt layer is proximity-magnetized by ferrimagnetic insulating $Y_3Fe_5O_{12}$ (YIG) underneath it. Moreover, *structural* inversion asymmetry and strong spin-orbit coupling (SOC) at the Pt/YIG interface forms the Rashba-type SOC. In Fig. 1d, the scale bar is 0.5 $\mu$m.

Fig. 1e and f show data equivalent to Fig. 1c and d but for the JJs with a Cu interfacial layer. In Fig. 1e and f, the Cu interfacial layer with weak SOC is inserted between the Pt and YIG layers not only to quench the Rashba-active interface but to suppress the proximity-induced exchange splitting in the Pt layer.

**Figure 2. Role of Rashba(-type) SOC in zero-field Josephson supercurrent rectification.**

Fig. 2a: Zero-field current-voltage $I$-$V$ curves of the magnetic 5-nm-thick Pt Josephson junction (JJ) for two different Pt magnetization $M_{Pt}$ (// $\pm x$-axis) below the junction's superconducting transition temperature $T_c$. Note that $\mu_0 H_\| = \pm 30$ mT, much larger than the coercive field of YIG, is first applied along the x-axis and then returned to zero to initialize the remanent-state $M_{Pt}$ in the $\pm x$-direction. In the yellow (cyan) shaded regime, the Josephson supercurrent flows only in the positive (negative) x-direction, as indicated by the diode symbols.

Fig. 2b: Data equivalent to Fig. 2a but for the JJ with a Cu(5 nm) interfacial layer.

$$Q_{\mu_0 H = 0} = \left[\frac{I_c^+ - |I_c^-|}{I_c^+ + |I_c^-|}\right]_{\mu_0 H = 0} = \left[\frac{\Delta I_c}{2 I_c^{avg}}\right]_{\mu_0 H = 0}$$

Fig. 2c and d: Summary of the *zero-field* diode efficiency as a function of normalized temperature $T/T_c$ for the Pt JJs with various Cu thicknesses (0, 5 and 10 nm). In Fig. 2c (d) the remanent-state $M_{Pt}$ is in the positive (negative) x-direction.

**Figure 3. Magnetic field-strength and angle dependences of the Josephson supercurrent non-reciprocity.**

Fig. 3a shows critical current asymmetry $\Delta I_c \, (= I_c^+ - |I_c^-|)$ versus in-plane (IP) magnetic-field strength $\mu_0 H_\parallel$, plot for the magnetic 5-nm-thick Pt Josephson junction (JJ), taken at the fixed azimuthal angle $\gamma = 90^0$ of the Pt magnetization $M_{Pt}$ with reference to the +y-axis. The inset displays the Josephson critical current $I_c$ as a function of $\mu_0 H_\parallel$, from which $\Delta I_c(\mu_0 H_\parallel)$ is extracted.

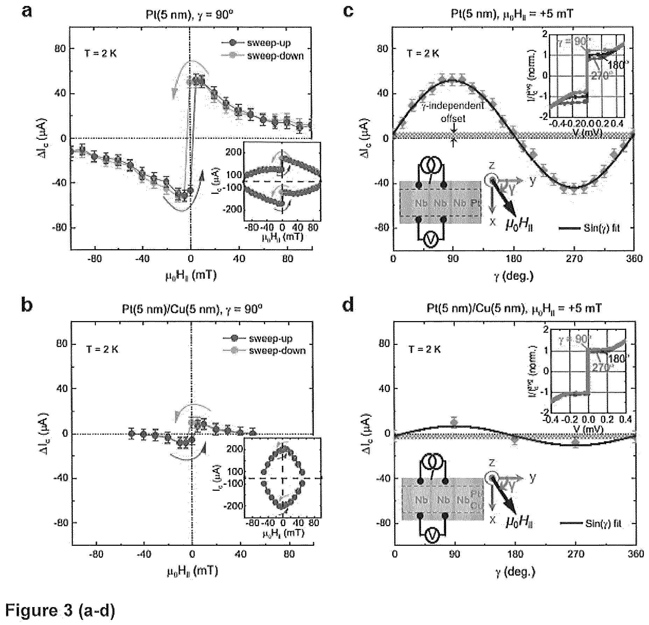

Fig. 3c, $\gamma$-dependent $\Delta I_c$ of the 5-nm-thick Pt JJ at the constant $\mu_0 H_\parallel = 5$ mT, which is applied to rotate $M_{Pt}$ ($//\mu_0 H_\parallel$) in the plane. In the top inset, typical current-voltage *I-V* curves of the 5-nm-thick Pt JJ for $\gamma = 90^0$, $180^0$ and $270^0$ are presented. Note that *I* is normalized by $I_c^{avg} \, \left(= \frac{I_c^+ + |I_c^-|}{2}\right)$. The bottom inset illustrates the measurement configuration. In Fig. 3c, the gray shaded regime represents the $\gamma$-independent $\Delta I_c$ offset, presumably caused by extrinsic effects. Fig. 3b and d, show data equivalent to Fig. 3a and c but for the JJ with a Cu(5 nm) interfacial layer.

**Figure 4. Zero-field Josephson diode efficiency relying on the degree of magnetic proximity coupling.**

Fig. 4a shows zero-field current-voltage *I-V* curves of the magnetic 3-nm-thick Pt Josephson junction (JJ) for two different Pt magnetization $M_{Pt}$ ($// \pm x$-axis), taken at the fixed temperature $T = 2$ K, far below the junction's superconducting transition $T_c$. Note that *I* is normalized by $I_c^{avg} \, \left(= \frac{I_c^+ + |I_c^-|}{2}\right)$.

Fig. 4b, representative *I-V* curves of the 3-nm-thick Pt JJ for three different azimuthal angles $\gamma = 90^0$, $180°$ and $270^0$, taken at a constant $\mu_0 H_\parallel = 5$ mT.

Fig. 4c and d show data equivalent to Fig. 4a and b but for the 10-nm-thick Pt JJ.

$$Q_{\mu_0 H = 0} = \left[\frac{I_c^+ - |I_c^-|}{I_c^+ + |I_c^-|}\right]_{\mu_0 H = 0} = \left[\frac{\Delta I_c}{2 I_c^{avg}}\right]_{\mu_0 H = 0}$$

Fig. 4e and f: Summary of the *zero-field* diode efficiency as a function of normalized temperature $T/T_c$ for the Pt JJs with various Pt thicknesses (3, 5 and 10 nm). In Fig. 4e (f), the remanent-state $M_{Pt}$ is in the positive (negative) x-direction.

**Figure 5. Schematic of a Racetrack Memory according to the invention**

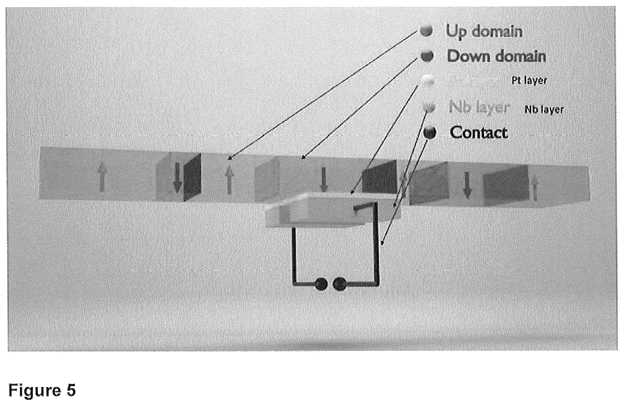

Figure 5 shows the racetrack memory comprising a racetrack layer, a writing line (not shown) and a Reading element based on a polarity-reversible Josephson supercurrent Diode.

Detailed description of the invention

The present invention is based on the surprising effect that a Pt layer can be used for "exchange transferring" a magnetic field from a permanent magnetic material (e.g. $Y_3Fe_5O_{12}$=YIG) which is in close proximity to the Pt layer to a JJ (see: Jeon, KR., Kim, JK., Yoon, J. et al. Zero-field polarity-reversible Josephson supercurrent diodes enabled by a proximity-magnetized Pt barrier. Nat. Mater. (2022). https://doi.org/10.1038/s41563-022-01300-7). The close proximity of a magnetic layer to the Pt layer "makes" the Pt layer magnetic. The magnetic Pt layer exhibits a strong spin-orbit-coupling (SOC) and at the same time functions as a Rashba-type Josephson barrier that weakly links the two adjacent superconductors (see Fig. 1c).

The present inventors have surprisingly found that even a magnetic exchange field of much lower strength than the one created by the YIG layer in Jeon et al. above is capable of proximity magnetizing the Pt layer, which means that even the comparatively low magnetic exchange field strength (compared to YIG) of a racetrack memory layer could be used to magnetize the Pt layer and in turn trigger the Josephson Diode Effect so that such a JJ can be used as a reading element in a racetrack memory device.

Accordingly, the present invention comprises a racetrack (RT) memory wherein the reading element comprises a polarity-reversible Josephson Diode (= JD). The Josephson Junction (JJ) in the RT memory of the present invention comprises two or more superconducting electrodes, which are each separated by an ultrathin crystalline Pt layer or Pt-alloy layer (see Fig. 5).

In order to separate the superconducting electrodes several spatial arrangements can be used: the electrodes can be arranged next to each other - e.g. as bars - with the required lateral spacing which spacing can then be filled with the crystalline Pt layer or Pt-alloy layer. This design can be manufactured in sequence, i.e. beginning with the first superconducting electrode, followed by the Pt layer or Pt-alloy layer and then the second superconducting electrode; or it can be manufactured in a parallel way by first manufacturing two laterally spaced superconducting electrodes and then filling the gap between the two superconducting electrodes with the Pt layer or Pt-alloy layer; or by first manufacturing the Pt layer or Pt-alloy layer, which is subsequently laterally sandwiched between two superconducting electrodes. In another, preferred, alternative the superconducting electrodes can be arranged on top of the crystalline Pt layer or Pt-alloy layer as it is shown in Fig. 1c. In another arrangement of the superconducting electrodes these can be vertically arranged so that the Pt or Pt-alloy layer is disposed vertically between the two superconducting electrodes. This geometry is especially useful for a 3D racetrack memory device e.g. where the racetrack is formed on a vertical sidewall.

In general

- the lateral spacing between the superconducting electrodes, and, thus, the width of the junction formed by the crystalline Pt layer or Pt-alloy layer is from about 3 nm to 1000 nm, preferably 3 to 100 nm, more preferred 5 to 20 nm;

- the thickness of each superconducting electrode independently from one another is typically in the range of 2 to 100 nm, preferably, 5 to 100 nm, more preferred 5 to 50 nm;

- the length of a superconducting electrode is typically in the range of 5 to 1000 nm, preferably, 5 to 100 nm, more preferred 5 to 50 nm;

- the width of a superconducting electrode is - independently from one another - typically in the range of 3 to 1000 nm, preferably, 3 to 100 nm, more preferred 5 to 20 nm;

- the thickness of the Pt or Pt-alloy layer, which forms the JD is typically in the range of 1 to 20 nm, preferably, 2 to 10 nm, more preferred 2 to 5 nm.

The superconducting electrodes are made of a typical conventional superconducting material. Typical conventional superconducting materials which can be used for this purpose are known and e.g. described in https://en.wikipedia.org/wiki/List_of_super-conductors, examples of which are: Al, Be, Bi, Ga, Hf, $\alpha$-La, $\beta$-La, Mo, Nb, Os, Pb, Re, Rh, Ru, Sn, Ta, $\alpha$-Th, Ti, V, $\alpha$-W, $\beta$-W, Zn, Zr, $FeB_4$, InN, $In_2O_3$, $LaB_6$, $MgB_2$, $Nb_3Al$, $NbC_{1-x}N_x$, $Nb_3Ge$, NbO, NbN, $Nb_3Sn$, NbTi, TiN, $V_3Si$, $YB_6$, ZrN, $ZrB_{12}$, YBCO (Yttrium barium copper oxide), BSCCO (Bismuth strontium calcium copper oxide), HBCCO (Mercury bismuth calcium copper oxide), preferably Nb or NbN. A 2D material that is superconducting could also be used such as $2H\text{-}NbSe_2$.

The crystalline Pt or Pt-alloy layer is either a crystalline Pt layer or a Pt-alloy layer, wherein the Pt is homogeneously mixed (=blended) with 1 to 70 atom%, preferably 5-40 atom-%, more preferred 10-30 atom-% (atom-% are based on Pt) of a metal preferably selected from Bi, Re, Os, Ir, Au, Ru, Rh, Pd, Al, Ga. The Pt-alloy can be a binary, ternary or even higher mixture of Pt with one, two or more of the metals selected from the above list. When two or more of the above listed metals are blended with the Pt, the above atom-% refer to the sum of the blended metals. The crystal structure of the alloy is preferably cubic as for Pt, but other crystal structures may also be preferred depending on the composition and structure of the racetrack. Recently racetracks formed using $L_{10}$ materials solely or in combination with cubic materials have been formed. Thus, the use of Pt alloys that exhibit an $L_{10}$ alloy may also be preferred. Examples include Pt-Al and Pt-Ga in which the Pt content can be as little as ~30 atomic percent.

In order for the JJ of the present invention to work as a reading element in a racetrack memory, the crystalline Pt or Pt-alloy layer of the JJ needs to be in "proximity" to the racetrack layer, so that an exchange transfer of the magnetization from the racetrack to the Pt or Pt-alloy layer is brought about. Therefore, whenever used herein, "proximitizing" or "proximity" means that two materials, preferably two layers are arranged next to each other, either by forming a joint phase boundary (= zero distance) or by being spaced apart by a separating layer of 0.5-100 nm, preferably 0.5-10 nm, most preferred 0.5-5.0 nm. The separating layer can be selected from a second Pt or Pt-alloy layer that is distinct from the first one. The Pt or Pt-alloy layer needs to be in close proximity to the magnetic layers within the racetrack but the extent of this layer does not need to fully cover the racetrack across the complete width of the racetrack but can only cover a part of the racetrack e.g. from either side or in the center of the racetrack. Similarly, the Pt or Pt-alloy layer could be wider than the width of the racetrack to allow, for example, for the easier fabrication and integration of the superconducting electrodes. The preferred case is where the Pt or Pt-alloy layer that separates the two superconducting electrodes is fully covered by the magnetic racetrack and where the extent (length) of the Pt layer along the racetrack is smaller than the separation between successive DWs.

The racetrack (RT) itself is preferably a ferromagnetic or synthetic antiferromagnetic (SAF) racetrack. A typical RT layer consists of multiple layers, which together form the RT layer. The basic structure of a racetrack is typically based on a ferromagnetic structure or a synthetic antiferromagnetic structure. The synthetic antiferromagnetic structure may be comprised of two ferromagnetic layers coupled antiferromagnetically via an antiferromagnetic coupling layer, which is typically comprised of a transition metal like Ru or Ir. The ferromagnetic structure comprises one or more, preferably two or three layers of a ferromagnetic material which is typically selected from one or more of Co, Ni, or Fe or an alloy of Fe and/or Co, or an alloy of Ni that may further include one or more of Fe and Co. Typically, the racetrack structure has a total thickness in the range of 0.5 to 3.0 nm. Each individual layer of the racetrack structure may have a thickness in the range of 0.1 nm - 1.5 nm. The structure is composed of multiple thin magnetic layers so that the multilayered structure exhibits a PMA (Perpendicular Magnetic Ansotropy) that is usually derived from the interfacial properties of the multilayered structure.

The individual layers of the racetrack device can be prepared with various techniques, depending on the kind of material. Films can be prepared from the elements, alloys or homogenous element mixtures. Manufacturing techniques such as chemical solution deposition (CSD), spin coating, chemical vapor deposition (CVD), plasma enhanced CVD, atomic layer deposition (ALD), molecular layer deposition (MLD), electron beam evaporation, molecular beam epitaxy (MBE), sputtering, pulsed laser deposition, cathodic arc deposition (arc-PVD) or electrohydrodynamic deposition can be used to manufacture the films. For example, films can be prepared by (co-) sputtering of the elements, eventually on top of a substrate. If it is desired to provide a film with a surface having a predefined crystallographic orientation, (co-) sputtering can be performed by way of epitaxial growth on a corresponding substrate exhibiting the desired crystallographic orientation with identical or similar unit cell dimensions as the to be grown compound. All of the above methods are generally known in the art.

Due to its unique performance at low temperatures the racetrack memory according to the present invention is specifically well suited for quantum computers preferably cryogenic-quantum computers.

Surprisingly, the JJ reading element can also be used for the local pinning or trapping of the domain walls in the racetrack according to the present invention, thereby allowing for the reliable synchronous displacement of a series of domain walls along the racetrack to predetermined positions along the racetrack.

The present invention will be illustrated by the following examples.

Examples

A lateral JJ (Fig. 1c and d) was fabricated, in which multiple superconducting Nb electrodes are separated by an ultrathin crystalline Pt layer that is proximity-magnetised by ferrimagnetic insulating $Y_3Fe_5O_{12}$ (YIG) films that are situated underneath the Pt layer.

The *magnetic* Pt layer with a strong SOC, functions as the Rashba-type Josephson barrier that weakly links the two adjacent Nb Superconductors.

As illustrated in Fig. 1a, if the magnetization orientation $M_{Pt}$ of the Pt weak link has a component *(// x-axis)* perpendicular to both the directions of its *structure* inversion asymmetry *(// z-axis)* and the current flow *(// y-axis)*, the associated exchange spin-splitting $\Delta E_{ex}$ and the Rashba(-type) SOC $\Delta k_R$ acting on conduction electrons form a nontrivial in-plane (IP) spin-textured Fermi contour in *k*-space. This leads to the *effective* non-sinusoidal CPR of the magnetic Pt JJ with unequal positive- and negative *I* branches ( $I_c^+ \neq |I_c^-|$ , Fig. 1b), that is, the so-called Josephson supercurrent diode effect. With this proximity-optimised Pt JJs, a *zero-external-field* diode efficiency

$$Q_{\mu_0 H = 0} = \left[ \frac{|I_c^+ - |I_c^-||}{I_c^+ + |I_c^-|} \right]_{\mu_0 H = 0} = \left[ \frac{\Delta I_c}{2 I_c^{avg}} \right]_{\mu_0 H = 0} \qquad \sqrt{1 - \frac{T}{T_c}}$$

of up to $\pm 35\%$ at 2 K was accomplished and its dependence witnessed. Further measurements of IP field-strength/angle dependences and comparison with a Cu-inserted control JJs (Fig. 1d) identified the crucial role of the exchange spin-splitting and the Rashba(-type) SOC at the Pt/YIG interface for the giant $Q_{\mu_0 H = 0}$, which is in good agreement with the Josephson $\varphi_0$ -junction theory. Asymmetric out-of-plane (OOP) magnetic-field interference patterns at $\mu_0 H_\parallel = 0$ conclusively support the presence of non-zero $\varphi_0$ in the magnetic Pt JJs.

Figure 2a shows typical current-voltage *I-V* curves of the magnetic 5-nm-thick Pt JJ for two different $M$Pt(//

$\pm x$-axis) below the junction's $T_c$, taken at $\mu_0 H_\parallel = 0$. Clearly, a zero-field asymmetry of $\Delta I_c = I_c^+ - |I_c^-| \neq 0$ is observed and its polarity is reversed ($\Delta I_c > 0 \rightarrow \Delta I_c < 0$) while retaining the linear scaling regime of $V$ with higher $|I|$ (>> $I_c^{avg}$) when inverting $M_{Pt}$ from the positive to the negative x-direction. In particular, over the broad $|I|$ window of 120 and 180 $\mu$A at $T = 2$ K, the Josephson supercurrent flows in one direction that can be preconfigured and controlled by the remanent-state $M_{Pt}$. This demonstrates the zero-field, polarity-switchable Josephson supercurrent rectification in a $^4$He cryostat.

By contrast, the Cu-inserted control JJs, in which a 5- (Fig. 2b) or 10-nm-thick Cu interfacial layer with weak SOC is inserted between the Pt and YIG layers as the Rashba-decoupling and proximity suppression layer, reveal no significant zero-field rectification relative to $I_c^{avg}$. For quantitative comparison, $Q_{\mu 0 H = 0}$ was plotted as a function of $T/T_c$ for the 5-nm-thick Pt JJs with and without the Cu interfacial layer (Fig. 2c and d). In the absence of the Cu layer, $|Q_{\mu 0 H = 0}|$ increases progressively with decreasing $T/T_c$ and approaches around 17% at $T/T_c = 0.5$ whereas this progressive increase remarkably diminishes (almost vanishes) when the 5- (10-)nm-thick Cu is present. This, along with an insignificant $|Q_{\mu 0 H = 0}| < 2\%$ of the Cu-only reference JJ (Extended Data Fig. 3), indicates that the Rashba-type SOC derived from the *structure* inversion asymmetry plus strong SOC and the magnetic proximity effect at the Pt/YIG interface are indeed key for the large $|Q_{\mu 0 H = 0}|$, in line with the Josephson $\varphi_0$-conjunction having the magnetic Rashba barrier described above.

To understand the underlying origin of the zero-field polarity-switchable $\Delta I_c$, it was next investigated how $\Delta I_c$ depends on the $\mu_0 H_\parallel$ strength at a fixed $\gamma = 90^0$ (Fig. 3a and d) and how it scales with $\gamma$ at a constant $\mu_0 H_\parallel = 5$ mT (Fig. 3b and d). In Fig. 3a, $\Delta I_c$ and $I_c$ (inset) are plotted as a function of $\mu_0 H_\parallel$ for the magnetic 5-nm-thick Pt JJ, from which one can clearly see asymmetric *hysteretic* $\Delta I_c(\mu_0 H_\parallel)$ curves with the extrema appearing around $\mu_0 H_\parallel = 0$. Apart from the low-field hysteretic $\Delta I_c(|\mu_0 H_\parallel| \leq 5$ mT) behaviour, mimicking the $\mu_0 H_\parallel$-driven reversal of $M_{Pt}$ ($//M_{YIG}$), $|\Delta I_c|$ is monotonically reduced at higher $\mu_0 H_\parallel$. These characterise the exchange-field-driven $\Delta I_c$ of the magnetic Pt JJ, whose *effective* $\Delta E_{ex}$, being as large as 0.8 meV, corresponding to the internal spin-splitting field of 9000 mT, readily produces $|\Delta I_c| \approx 60$ $\mu$A without the need of any $\mu_0 H_\parallel$. In the case of the Zeeman-field-driven $\Delta I_c$ in nonmagnetic NM-based JJs, $\Delta I_c$ has been found to be *linear* in $\mu_0 H_\parallel$ up to a breakdown field (75 mT), above which the supercurrent rectification quenches rapidly.

Given that $\dfrac{\Delta I_c}{2 I_c^{avg}} \sim \dfrac{\varphi_0}{\pi} \propto sin(\gamma)$, a fair fit to $\gamma$-dependent $\Delta I_c$ data of the magnetic Pt JJ with a sine function (Fig. 3b) ensures an intrinsic magnetochiral origin of its Josephson supercurrent rectification. Note that there also exists a small $\Delta I_c$ offset of < 5 $\mu$V ( $\dfrac{\Delta I_c}{2 I_c^{avg}} < 3\%$ ), which is $\gamma$-independent and thus has nothing to do with the magnetochirality of interest. When the 5-nm-thick Cu interfacial layer is inserted, the asymmetric hysteretic $\Delta I_c(\mu_0 H_\parallel)$ behaviour (Fig. 3c) and the characteristic $sin(\gamma)$ dependence (Fig. 3d) fade away, signifying the key role of the Pt/YIG Rashba-active interface for the Josephson supercurrent non-reciprocity.

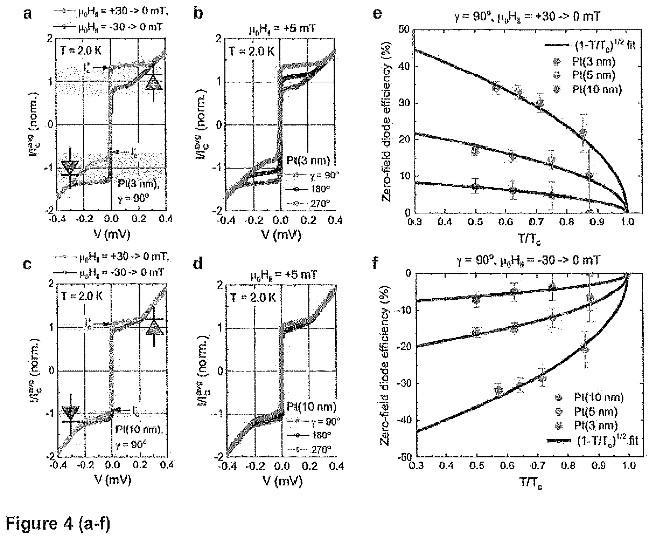

For given values of $\gamma$, $\alpha_R$ and $L$, $|Q_{\mu 0 H = 0}|$ is expected to scale directly with $\Delta E_{ex}$, another distinctive feature of the field-free Josephson $\varphi_0$-junction. To prove this, the Pt barrier thickness $t_{PT}$ was varied from 3 to 10 nm (Fig. 4). The anomalous Hall resistivity $\rho_{AH}$ under an OOP magnetic field $\mu_0 H_\perp$, providing a measure of $\Delta E_{ex}$ in the proximity-magnetised Pt, decreases strongly with increasing $t_{Pt}$. This is in accordance with the magnetic proximity effect in Pt/YIG bilayers that is in the $\dfrac{1}{t_{Pt}}$ decay regime. Using $\Delta E_{ex}(t_{Pt}) \approx \dfrac{|G_i|}{\left(\dfrac{e^2}{\hbar}\right) g_F t_{Pt}} 30$, where $|G_i| \approx 1 \times 10^{13} \Omega^{-1} m^{-2}$ is the imaginary part of spin-mixing conductance at the Pt/YIG interface and $g_F \approx 3\text{-}4 \times 10^{28}$ m$^{-3}$eV$^{-1}$ is the density-of-states of the Pt layer at the Fermi level, the *effective* $t_{Pt}$-dependent $\Delta E_{ex} \approx 1.3$, 0.8 and 0.4 meV for $t_{Pt} = 3$, 5 and 10 nm, respectively, was obtained.

Notably, with the $t_{Pt} = 3$ nm Pt JJ (Fig. 4a and b), the pronounced $|Q_{\mu 0 H = 0}|$ of up to 35% at 2 K could be achieved by proximity-enhancing the effective $\Delta E_{ex}$. Its non-reciprocity is also rigorously controlled by rotating $M_{Pt}$ (Fig. 4b). When the Pt becomes thicker ($t_{Pt} \pm 10$ nm, Fig. 4c and d), $|Q_{\mu 0 H = 0}|$ at 2 K is largely reduced to 7%, supporting the proportionality of $|Q_{\mu 0 H = 0}|$ to $\Delta E_{ex}$. By plotting $|Q_{\mu 0 H = 0}|$ as a function of $T/T_c$ for different $t_{Pt}$ (Fig. 4e and f), the intrinsic $\varphi_0$-junction properties of the Pt JJs were further identified. Importantly, for all the junctions, $|Q_{\mu 0 H = 0}|$ rises progressively as $T/T_c$ goes down and down, and $|Q_{\mu_0 H = 0}(T/T_c)|$ is well fitted by a $\sqrt{1 - \dfrac{T}{T_c}}$ function. This is what would be theoretically expected for the Josephson $\varphi_0$-junctions regardless of the type of the JJs (i.e. ballistic or diffusive junction) and irrespective of what (e.g. Zeeman or Exchange field) causes the necessary spin-splitting (Fig. 1a).

When the JJ is in the diffusive regime, $\varphi_0$ can, in principle, be spatially-dependent due to finite disorder in a Josephson barrier and anomalous variations in $\varphi_0(x)$ along the $x$-direction can lead to asymmetric OOP magnetic-field interference patterns $I_c(\mu_0 H_\perp)$ in the presence of IP spin-splitting. The measured $I_c(\mu_0 H_\perp)$ patterns at $\mu_0 H_\parallel = 0$ for the 3-nm-thick Pt JJ are strongly asymmetric with respect to $\mu_0 H_\perp = 0$ and this asymmetric $I_c(\mu_0 H_\perp)$ pattern is clearly inverted when the remanent-state $M_{Pt}$ flips from the positive to negative $x$-direction. This observation decisively supports the existence of non-zero $\varphi_0$ in the magnetic Pt JJ. By theoretically reproducing the observed asymmetric $I_c(\mu_0 H_\perp)$ patterns, it was found that owing to the significant exchange spin-splitting in the 3-nm-thick Pt ($\Delta E_{ex} \approx 1.3$ meV), a small change of Rashba SOC $\Delta \alpha_R = 0.001$ eVÅ along the x-direction can readily generate a phase variation of $\Delta \varphi_0(x) \approx \pi/9$.

## Methods

**Sample preparation and device fabrication. Prior to the lithographic device** fabrication, three different types of normal metal (NM) structures of Pt(3-10 nm), Pt(5 nm)/Cu(5-10 nm) and Cu(5 nm) were prepared on top of 200-nm-thick single-crystalline YIG films, which were grown by liquid phase epitaxy on a (111)-oriented single-crystalline $Gd_3Ga_5O_{12}$ (GGG) wafer, at room temperature by d.c. magnetron plasma sputtering in an ultra-high vacuum system with a base pressure of $1 \times 10^{-9}$ Torr. All these films were sputtered at 27 °C with a sputter power of 15 W and at an Ar pressure of 3 mTorr, and were capped with a 1-nm-thick sputter deposited $AlO_x$ layer to prevent oxidation. To fabricate the lateral JJs (Fig. 1d and f), a central NM track with lateral dimensions of $1.5 \times 50$ $\mu m^2$ is first defined using optical lithography and Ar-ion beam etching. Electrical leads were then defined and bonding pads, formed from Au(80 nm)/Ru(2 nm), which were deposited by Ar-ion beam sputtering. Subsequently, multiple Nb electrodes with active lateral dimensions of $1.0 \times 1.5$ $\mu m^2$ were defined on top of the NM track via electron-beam lithography and lift-off steps. The 50-nm-thick Nb electrodes were grown by Ar-ion beam sputtering at an Ar pressure of $1.5 \times 10^{-4}$ mbar. Note that the edge-to-edge separation $L$ between the adjacent Nb electrodes (Fig. 1d and f) was fixed at approximately 100 nm to maximise the Josephson supercurrent rectification ($\propto L^3$) while keeping detectably large critical currents at 2 K in a $^4$He cryostat. Before sputtering the Nb electrodes, the $AlO_x$ capping layer and Au surface were Ar-ion beam etched away to make possible direct metallic electrical contacts.

The proximity effect of singlet Cooper pairs in a magnetic Josephson barrier can be characterised by its co-

herence length, $\xi_F^+ = \sqrt{\dfrac{\hbar D}{\sqrt{(\Delta E_{ex})^2 + (\pi k_B T)^2} + \pi k_B T}}$ . From this formula using $D \approx 0.5\text{-}10$ cm$^{-2}$s$^{-1}$ and $\Delta E_{ex} = 0.4\text{-}1.3$

meV for $t_{Pt}$ = 3-10 nm, $\xi_F^+ = 10-40$ nm was obtained, which is approximately one order of magnitude larger than $l_{mfp}$ of the Pt thin film. Hence, the Pt JJs with $L \approx 100$ nm used in this example are in the diffusive regime.

**Josephson transport measurement and data analysis.** Current-voltage $I$-$V$ curves of the fabricated JJs (Fig. 1d and f) were measured with a 4-probe configuration in a Quantum Design Physical Property Measurement System using a Keithley 6221 current source and a Keithley 2182A nanovoltmeter. Prior to the *zero-field I-V* measurements (Fig. 2a and b, Fig. 4a and b) below the junctions' $T_c$ (< 6 K), $\mu_0 H_\parallel = \pm 30$ mT that is much larger than the coercive field of YIG was first applied along the x-axis and then returned to zero to initialize the remanent-state $M_{Pt}$ in the $\pm x$-direction. The Josephson critical current $I_c$ was determined by fitting the measured $I$-$V$ curves with the standard formula for

overdamped junctions, $V(I) = \dfrac{I}{|I|} R_n \sqrt{I^2 - I_c^2}$ . When thermal noise/rounding effects $\left( \propto \dfrac{T}{I_c} \right)$ on the $I$-$V$ curves become significant, especially for the 3-nm-thick Pt JJ, the $I_c$ value was determined at the point where $V(I) \approx 1$ $\mu$V. the magnetic-field strength dependences of $I_c(\mu_0 H)$ and $\Delta I_c(\mu_0 H)$ (Fig. 3a and c) was obtained by repeating the $I$-$V$ measurements at $T = 2$ K at the applied $\mu_0 H_\parallel$ ($\mu_0 H_\perp$), parallel (perpendicular) to the interface plane of Nb electrodes. All the $I_c(\mu_0 H)$ and field-angle-dependent $I_c(\gamma)$ measurements (Fig. 3b and d) were performed using a horizontal sample rotator.

Asymmetric OOP magnetic-field interference patterns $I_c(\mu_0 H_\perp)$ of the diffusive JJ, caused by the spatial-dependent $\varphi_0(x)$ due to disorder, can be described by

$$I_c(\mu_0 H_\perp) \approx \max_\varphi \int_{-w/2}^{+w/2} A(x)\left\{I_{c1}\sin\left[\varphi + \varphi_{\mu_0 H_\perp}(x) + \varphi_0(x)\right] + I_{c2}\sin\left[2\varphi + 2\varphi_{\mu_0 H_\perp}(x)\right]\right\}dx$$

. Here $A(x)$ describes a non-uniform supercurrent density distribution from structural disorder of the barrier along the x-direction, $\varphi$ is the global phase difference, $\varphi_{\mu_0 H_\perp} = 2\pi\dfrac{\mu_0 H_\perp(2\lambda_L + L)x}{\Phi_0}$ , $\lambda_L$ is the London penetration depth of the superconducting Nb electrodes, w is the width of the Josephson barrier and $\Phi_0 = \dfrac{h}{2e} = 2.07\times10^{-15}$ Tm$^2$ is the magnetic flux quantum. Both $A(x)$ and $\varphi_0(x)$ are assumed to have a sinusoidal/spatial dependence for the sake of simplicity. From $\varphi_0(x) = \dfrac{\tau m^* \Delta E_{ex}(\alpha_R(x)L)^3}{3\hbar^6 D}$ where $\gamma = 90^0$, $\tau \approx 0.01$ ps, $m^* = 9.1 \times 10^{-31}$ kg, $\Delta E_{ex} \approx 1.3$ meV and $D \approx 0.5$ cm$^{-2}$s$^{-1}$ for the 3-nm-thick Pt layer, $\alpha_R(x) = \alpha_0 A(x) = \alpha_0\left(1 - 0.95\sin\left[\dfrac{x}{w}\right]\right)$ and $L = 100$ nm, one can find that a local change of $\Delta\alpha_R = 0.001$ eVÅ owing to the finite structural disorder can generate a phase variation of $\Delta\varphi_0 \approx \pi/9$ along the $x$-direction.

This is large enough to reproduce the strong asymmetric $I_c(\mu_0 H_\perp)$ patterns observed in the 3-nm-thick magnetic Pt JJ.

**AHE measurement.** The anomalous Hall resistivity $\rho_{AH}$ was measured under application of $\mu_0 H_\perp$ to estimate the *effective* $\Delta E_{ex}$ in the proximity-magnetized Pt layers induced by the ferrimagnetic insulating YIG underneath it. Fitting the $\rho_{AH}(t_{Pt})$ data via a spin-Hall AHE theory,

$$\rho_{AH}(t_{Pt}) = -\frac{2(l_{sd}\theta_{SH})^2}{t_{Pt}}\,\text{Im}\,\frac{G_{\uparrow\downarrow}\tanh^2\left(\frac{t_{Pt}}{2l_{sd}}\right)}{\left(\frac{1}{\rho_{xx}} + 2l_{sd}G_{\uparrow\downarrow}\coth\left(\frac{t_{Pt}}{l_{sd}}\right)\right)^2}\,,$$

with $G_{\uparrow\downarrow} = G_r + iG_i$, yields the imaginary part of the spin-mixing conductance $G_i$ to the first order to be $\sim 1 \times 10^{13}$ $\Omega^{-1}$m$^{-2}$. In this fit, the estimated values of $l_{sd} = 1.2$ nm was used that is the Pt spin-diffusion length, $\theta_{SH} = 0.08$ that is the Pt spin-Hall angle, $G_r = 4.4 \times 10^{14}$ $\Omega^{-1}$m$^{-2}$ that is the real part of the spin-mixing conductance from similar Pt/YIG bilayers and the measured Pt resistivity $\rho_{xx}$ at $\mu_0 H_\perp = 0$.

## Claims

1.  Racetrack (RT) memory, comprising a racetrack layer and at least one reading element, wherein the reading element comprises a polarity-reversible Josephson supercurrent diode (= JJ).

2.  Racetrack (RT) memory according to claim 1, wherein the polarity-reversible Josephson Junction (JJ) comprises two or more superconducting electrodes which are each separated by a Pt or Pt-alloy layer.

3.  Racetrack (RT) memory according to claim 1 or 2, wherein the superconducting electrodes are independently selected from Al, Be, Bi, Ga, Hf, $\alpha$-La, $\beta$-La, Mo, Nb, Os, Pb, Re, Rh, Ru, Sn, Ta, $\alpha$-Th, Ti, V, $\alpha$-W, $\beta$-W, Zn, Zr, FeB$_4$, InN, In$_2$O$_3$, LaB$_6$, MgB2, Nb$_3$Al, NbC$_{1-x}$N$_x$, Nb$_3$Ge, NbO, NbN, Nb$_3$Sn, NbTi, TiN, V$_3$Si, YB$_6$, ZrN, ZrB$_{12}$, YBCO (Yttrium barium copper oxide), BSCCO (Bismuth strontium calcium copper oxide) and HBCCO (Mercury bismuth calcium copper oxide), preferably from Nb and NbN, more preferred from Nb.

4.  Racetrack (RT) memory according to claim 1, 2 or 3, wherein the crystal structure of the Pt-alloy is cubic.

5.  Racetrack (RT) memory according to one of claims 1-4, wherein the crystalline Pt-alloy exhibits an L$_{10}$ alloy.

6.  Racetrack (RT) memory according to claim 5, wherein the crystalline Pt-alloy is Pt-Al or Pt-Ga.

7.  Racetrack (RT) memory according to one of claims 1-5, wherein the crystalline Pt-alloy consists of Pt which is homogenously mixed (=blended) with 1-70 atom-% (atom-% are based on Pt) of a metal selected from Bi, Re, Os, Ir, Au, Ru, Rh, Pd, Al, Ga.

8. Racetrack (RT) memory according to claim 7, wherein the crystalline Pt-alloy is a binary, ternary or even higher mixture of Pt with one, two or more of the metals selected from Bi, Re, Os, Ir, Au, Ru, Rh, Pd, Al, Ga.

9. Racetrack (RT) memory according to one of claims 1 to 8, wherein

   - the Pt or Pt-alloy layer and
   - the racetrack layer

   form a joint phase boundary (= zero distance) or are spaced apart by a separating layer of 0.5-100 nm.

10. Racetrack (RT) memory according to one of claims 1 to 9 wherein the lateral spacing between the superconducting electrodes is from about 3 nm to 1000 nm.

11. Racetrack (RT) memory according to one of claims 1 to 10, wherein the thickness of each superconducting electrode independently from one another is in the range of 2 nm to 100 nm.

12. Racetrack (RT) memory according to one of claims 1 to 11, wherein the length of a superconducting electrode is in the range of 5 nm to 1000 nm.

13. Racetrack (RT) memory according to one of claims 1 to 12, wherein the width of a superconducting electrode is in the range of 3 nm to 1000 nm.

14. Racetrack (RT) memory according to one of claims 1 to 13, wherein the thickness of the Pt or Pt-alloy layer is in the range of 1 nm to 20 nm.

15. Method of manufacturing a Racetrack Memory (RT) according to claim 1, comprising preparing individual films and/or film layers of the individual elements of the racetrack memory from elements of the periodic system, alloys of two or more elements of the periodic system or homogenous mixtures of elements of the periodic system by chemical solution deposition (CSD), spin coating, chemical vapor deposition (CVD), plasma enhanced CVD, atomic layer deposition (ALD), molecular layer deposition (MLD), electron beam evaporation, molecular beam epitaxy (MBE), sputtering, pulsed laser deposition, cathodic arc deposition (arc-PVD) or electrohydrodynamic deposition.

16. Use of a memory according to claim 1 in a quantum computer.

17. Use of claim 16, wherein the quantum computer is a cryo-quantum computer.

18. Use of a polarity-reversible Josephson supercurrent diode for local pinning or trapping of the domain walls in a racetrack memory.

Figure 1 (a-f)

Figure 2 (a-d)

Figure 3 (a-d)

Figure 4 (a-f)

Figure 5

**Europäisches Patentamt**
**European Patent Office**
**Office européen des brevets**

# EUROPEAN SEARCH REPORT

Application Number

EP 22 20 6549

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| Y | PARKIN STUART: "Racetrack Memory: a high capacity, high performance, non-volatile spintronic memory", 2022 IEEE INTERNATIONAL MEMORY WORKSHOP (IMW), IEEE, 15 May 2022 (2022-05-15), pages 1-4, XP034127516, DOI: 10.1109/IMW52921.2022.9779286 [retrieved on 2022-05-25] * figures 1A-E * | 1-18 | INV. H10B61/00 H10N50/01 H10N50/10 H10N60/12 H10N69/00 |
| Y,D | JEON KUN-ROK ET AL: "Zero-field polarity-reversible Josephson supercurrent diodes enabled by a proximity-magnetized Pt barrier", NATURE MATERIALS, vol. 21, no. 9, 7 July 2022 (2022-07-07), pages 1008-1013, XP093041364, London ISSN: 1476-1122, DOI: 10.1038/s41563-022-01300-7 Retrieved from the Internet: URL:https://www.nature.com/articles/s41563-022-01300-7> * figures 2-4 * * Annex, section "Methods" * | 1-18 | |

TECHNICAL FIELDS SEARCHED (IPC)

H10B
H10N

The present search report has been drawn up for all claims

| Place of search | Date of completion of the search | Examiner |
|---|---|---|
| Munich | 24 April 2023 | Gröger, Andreas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

......................................................................

& : member of the same patent family, corresponding document

EPO FORM 1503 03.82 (P04C01)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 6834005 B

- US 2014204648 A

**Non-patent literature cited in the description**

- **JEON, KR. ; KIM, JK. ; YOON, J. et al.** Zero-field polarity-reversible Josephson supercurrent diodes enabled by a proximity-magnetized Pt barrier. *Nat. Mater.,* 2022, https://doi.org/10.1038/s41563-022-01300-7